(19) Europäisches Patentamt
European Patent Office
Office européen des brevets

(11) **EP 3 120 123 B1**

(12) **EUROPÄISCHE PATENTSCHRIFT**

(45) Veröffentlichungstag und Bekanntmachung des Hinweises auf die Patenterteilung:
**16.12.2020   Patentblatt 2020/51**

(21) Anmeldenummer: **15715133.3**

(22) Anmeldetag: **20.03.2015**

(51) Int Cl.:
*G01L 5/16* (2020.01)      *G01G 3/13* (2006.01)
*G01L 9/00* (2006.01)      *G01L 15/00* (2006.01)
*G01L 1/16* (2006.01)      *H01L 41/09* (2006.01)
*H01L 41/113* (2006.01)      *G01L 5/167* (2020.01)

(86) Internationale Anmeldenummer:
**PCT/CH2015/000044**

(87) Internationale Veröffentlichungsnummer:
**WO 2015/139149 (24.09.2015 Gazette 2015/38)**

(54) **PIEZOELEKTRISCHES MESSELEMENT ZUR MESSUNG DES DYNAMISCHEN UND STATISCHEN DRUCKES UND/ODER DER TEMPERATUR**

PIEZOELECTRIC MEASURING ELEMENT FOR MEASURING THE DYNAMIC AND STATIC PRESSURE AND/OR THE TEMPERATURE

ÉLÉMENT DE MESURE PIÉZOÉLECTRIQUE SERVANT À MESURER LA PRESSION DYNAMIQUE ET STATIQUE ET/OU LA TEMPÉRATURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.03.2014   CH 434142014**

(43) Veröffentlichungstag der Anmeldung:
**25.01.2017   Patentblatt 2017/04**

(73) Patentinhaber: **Kistler Holding AG
8408 Winterthur (CH)**

(72) Erfinder:
• **SOMMER, Roland
  CH-8413 Neftenbach (CH)**
• **CAVALLONI, Claudio
  CH-8105 Regensdorf (CH)**

(56) Entgegenhaltungen:
**EP-A1- 0 065 511      WO-A1-2006/037145
WO-A2-2012/164016      AT-A4- 503 558
AT-A4- 503 558**

EP 3 120 123 B1

## Beschreibung

### Technisches Gebiet

Die vorliegende Erfindung beschreibt eine Sensorstruktur mit einem Messelement gemäß den Ansprüchen 1 oder 2, sowie ein Verfahren zur Messung des statischen und dynamischen Druckes und/oder der Temperatur mit einem Messelement, gemäß Anspruch 12

### Stand der Technik

Messelemente, umfassend Piezoelektrika bzw. piezoelektrische Körper werden aufgrund ihrer speziellen Eigenschaften in einer Reihe von Sensorstrukturen mit Messelementen eingesetzt.

In der WO2012164016 wird eine Sensorstruktur offenbart, welche aus einer Mehrzahl von Messelementen, umfassend mehrere Körper aus piezoelektrischen Materialien, besteht. Die Messelemente sind zur Messung von Drücken und/oder Kräften einsetzbar. Die Sensorstruktur weist einen kompakten Aufbau auf, wobei die Messelemente aus piezoelektrischem Material voneinander beabstandet unter Ausnutzung des piezoelektrischen Effektes zur dynamischen Kraft- bzw. Druckmessung in einem Gehäuse vorgespannt stehend angeordnet sind. Über eine Membran werden Kräfte auf die Stirnflächen der Messelemente geleitet. Je nach Stauchung der Messelemente werden Messsignale zur Ermittlung der Kraft bzw. des Druckes aufgenommen. Für die Aufnahme von statischen Kraft- bzw. Druckmesswerten ist mindestens ein weiteres Messelement vorgesehen, welches den inversen piezoelektrischen Effekt ausnutzt und als Dickenscherschwinger betrieben wird. Dieser Dickenscherschwinger wird als piezoelektrischer Resonator betrieben und wird über aufgebrachte Elektroden auf den Seitenflächen des Messelementes mit einem elektronischen Anregungssignal zu entsprechenden Schwingungen angeregt. Je nach Kraft- bzw. Druckbeaufschlagung ändert sich die Resonanzfrequenz des Dickenscherschwingers, was zur Bestimmung der statischen Kraft bzw. des Druckes ausnutzbar ist.

Zur Schaffung einer solchen Sensorstruktur sind viele Bauteile nötig, die exakt im Gehäuse orientiert und befestigt, sowie sorgfältig elektrisch verkabelt werden müssen, damit die verschiedenen Messelemente nicht von der angeregten hochfrequenten Schwingung der anderen Messelemente bzw. der Anregungsspannung der verwendeten Elektronik gestört werden. Die Messelemente sind konstruktionsbedingt örtlich beabstandet, was die Platzierung und Kontaktierung der Messelemente im Gehäuse zwar erleichtert, aber zu Kraft- und/oder Druckmessungen an örtlich verschiedenen Punkten führt, woraus Messungenauigkeiten resultieren.

Um die Kraft- bzw. Druckmessung möglichst nahe an einem Ort reproduzierbar durchzuführen und die Messgenauigkeit zu erhöhen, wurde in der AT503558 ein anderer Weg begangen. Ein Messelement, umfassend einen Körper aus einem piezoelektrischen Material, welcher mit einem zusätzlichen zweiten Messelement, bestehend aus einem piezoelektrischen Messplättchen mit einer sogenannten SAW-Struktur (Surface Acoustic Wave), versehen wurde. Unter Ausnutzung des piezoelektrischen Effektes liefert das Messelement, wie bekannt, den vorherrschenden dynamischen Druck. Es wird eine weiter kompaktierte Sensorstruktur geschaffen, da die SAW-Struktur, das Messelement direkt berührend, auf dem Körper aus piezoelektrischem Material angeordnet ist. Das Messelement weist Flächenelektroden auf, welche auf die SAW-Struktur abgestimmt ebenfalls am Messelement befestigt werden müssen, bevor die Flächenelektroden und die SAW-Struktur mit einer Auswerte- und Anregungselektronik verbindbar sind.

Die EP0065511 offenbart einen Messwertaufnehmer zur Überwachung eines Verbrennungsvorganges in einem Brennraum einer Brennkraftmaschine. Der Messwertaufnehmer weist zwei piezoelektrischen Sensorelemente auf. Ein erstes piezoelektrisches Sensorelement misst unter Ausnutzung des direkten piezoelektrischen Transversaleffektes oder des direkten piezoelektrischen Longitudinaleffektes dynamische Druckschwankungen beim Verbrennungsvorgang. Ein zweites piezoelektrisches Sensorelement wird als piezoelektrischer Resonator betrieben und misst statische Druckschwankungen beim Verbrennungsvorgang. Die beiden piezoelektrischen Sensorelemente sind durch einen Druckübertragungskörper räumlich voneinander getrennt im Messwertaufnehmer angeordnet.

Mit der Auswerte- und Anregungselektronik werden entlang der SAW-Struktur im Messbetrieb Oberflächenwellen in Form von akustischen Wellen erzeugt, deren Laufzeiten sich je nach Kraftwirkung auf das Messelement bzw. die SAW-Struktur ändern. Aus der Änderung der Laufzeiten kann der Absolutdruck mittels SAW-Struktur ermittelt werden.

Obwohl die Fixierung der SAW-Struktur am Messelement zu einer mehrteiligen Sensorstruktur führt, welche eine Druck- bzw. Kraftmessung an nahezu dem gleichen Ort erlaubt, resultieren inhomogene Kraftverteilungen im Messelement und in der SAW-Struktur. Bei Befestigung der SAW-Struktur am Messelement, sowie der Anordnung der Flächenelektroden am Messelement muss sichergestellt werden, dass sich weder die beiden voneinander unabhängigen piezoelektrischen Elemente gegenseitig, noch die von diesen beiden piezoelektrischen Elementen ausgehenden Messsignale stören. Zur Erreichung der Sensorstruktur gemäss der AT503558 muss das Messelement mit dem piezoelektrischen Messplättchen mit der SAW-Struktur in einem geeigneten Herstellungsschritt exakt verbunden werden, was aufwändig und damit kostenintensiv ist.

### Darstellung der Erfindung

Die vorliegende Erfindung hat sich zur Aufgabe gestellt ein Messelement bzw. eine Sensorstruktur zu schaffen, welche einfacher, kostengünstiger unter Verwendung nur weniger Bauteile aufgebaut sind, wobei eine genauere dynamische und statische Kraft- und/oder Druckmessung und/oder Temperaturmessung durchführbar ist, als mit den Messelementen des Stands der Technik.

Diese Aufgabe wird dadurch gelöst, dass die Sensorstruktur nur ein Messelement, umfassend einen Körper aus einem geeigneten piezoelektrischen Material, welche in zwei Messmodi gleichzeitig betreibbar ist, aufweist. Da das Messelement einstückig nur einen piezoelektrischen Körper umfassend hergestellt ist, ist die Platzierung und die elektrische Kontaktierung wesentlich vereinfacht und die Kraft- bzw. Druckmessung bzw. Temperaturmessung beider Messmodi findet an einem Ort statt.

**Kurze Beschreibung der Zeichnungen**

Der Erfindungsgegenstand wird beispielhaft nachstehend im Zusammenhang mit den anliegenden Zeichnungen beschrieben.

| | |
|---|---|
| Figur 1a | zeigt eine Schnittansicht einer Sensorstruktur mit einem Messelement, umfassend einen piezoelektrischen Körper, dessen piezoelektrischer Effekt und inverser piezoelektrischer Effekt gleichzeitig zur Messwerterfassung ausnutzbar ist, während |
| Figur 1b | eine perspektivische Ansicht eines dazu geeigneten Messelementes gemäss Figur la zeigt. |
| Figur 2 | zeigt eine schematische Schnittansicht des piezoelektrischen Körpers beim Betrieb als Dickenscherschwinger, wobei die Scherung im Körper angedeutet ist. |
| Figur 3a | zeigt eine Schnittansicht einer Sensorstruktur mit einem Messelement, umfassend einen piezoelektrischen Körper, dessen piezoelektrischer Effekt und dessen inverser piezoelektrischer Effekt, im Betrieb als Dickenschwerschwinger gleichzeitig zur Messwerterfassung ausnutzbar ist, während |
| Figuren 3b | und 3c perspektivische Ansichten möglicher Gestaltungen von Messelementen zum Betrieb in einer Sensorstruktur gemäss Figur 3a zeigen, wobei in Figur 3c noch die Auswerte- und Anregungselektronik angedeutet ist. |
| Figur 4a | zeigt eine schematische perspektivische Ansicht eines Einkristalls mit Hauptachse, |

wobei ein piezoelektrischer Körper in einer Schnittebene in einem Winkel relativ zur Hauptachse geschnitten angedeutet ist, während

| | |
|---|---|
| Figur 4b | die Winkelabhängigkeit des Schubkoeffizienten und des Transversalkoeffizienten zu einem Schnittwinkel relativ zur Hauptachse beispielhaft für einen Quarzkristall zeigt. |

**Beschreibung**

Es wird ein Messelement 2 beschrieben, welches in einer Sensorstruktur 0 lagerbar ist und zur Druckmessung des dynamischen und/oder statischen Druckes und/oder zur Temperaturmessung, beispielsweise bei Anordnung in einem Verbrennungsraum eines Motors, einsetzbar ist. Die Sensorstruktur 0 setzt sich aus dem Messelement 2 und einer Messelementaufnahme 1 zusammen.

Das Messelement 2 weist einen einstückigen Körper 20 aus einem piezoelektrischen Material auf, welcher in der Messelementaufnahme 1 lagestabil so gelagert ist, dass das Messelement 2 bzw. der Körper 20 Kräfte im Messbetrieb aufnehmen kann. Das Messelement 2 wird dazu in der Messelementaufnahme 1 lösbar oder unlösbar form- und/oder kraftschlüssig entlang einer Longitudinalrichtung L eingespannt gelagert.

Hier ist eine Membran 10, sowie ein Widerlager 11 als Teil der Messelementaufnahme 1 vorgesehen, zwischen denen der Körper 20 eingespannt ist. Im Betrieb des Messelementes 2 können Kräfte F, welche in Richtung der Longitudinalrichtung L auf den Körper 20 wirken, ermittelt werden, woraus der vorherrschende Druck P ermittelbar ist. Der Körper 20 weist eine erste Seitenfläche 21 auf, auf welcher eine erste Seitenflächenelektrode 210 angeordnet ist. Auf einer zweiten Seitenfläche 22, in einer Transversalrichtung Ta gegenüberliegend der ersten Seitenfläche 21 angeordnet, ist eine zweite Seitenflächenelektrode 220 angeordnet. Bei einer Kraft- bzw. Druckwirkung in Longitudinalrichtung L auf den Körper 20 kann ein Spannungssignal oder ein Ladungssignal an einer Auswerte- und Anregungselektronik 3 gemessen werden. Die Auswerte- und Anregungselektronik 3 ist über Zuleitungen mit beiden Seitenflächenelektroden 210, 220 verbunden.

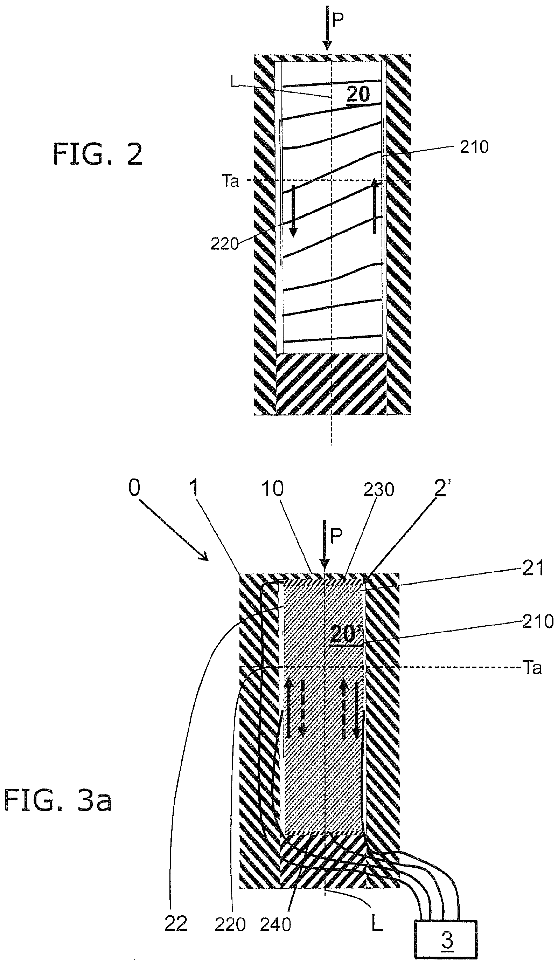

Das hier vorgestellte Messelement 2 ist in zwei Messmodi gleichzeitig betreibbar ausgeführt, wobei durch Ausnutzung des piezoelektrischen (oder direkten piezoelektrischen) Effektes, in Form des Transversaleffektes der dynamische Druck und durch Ausnutzung des inversen piezoelektrischen Effektes, durch Ausbildung des Messelementes 2 als Dickenscherschwinger, der statische Druck gleichzeitig mittels demselben Messelement 2 gemessen werden kann. Die elektronische Anregung des Körpers 20 mit einer Dickenscherschwingfrequenz f erfolgt ebenfalls durch die mit den Seitenflächenelektroden 210, 220 verbundene Auswerte- und Anregungselektronik 3. Die Dickenscherschwingung erfolgt parallel zur Longitudinalrichtung oder quer dazu und ist durch Pfeile angedeutet, wird aber noch genauer in Figur 2 gezeigt. Da hier die Anregung der Dickenscherschwingung und die Ladungsmessung aufgrund des Transversaleffektes an den Seitenflächenelektroden 210, 220 erfolgt sind nur zwei Zuleitungen zur Auswerte- und Anregungselektronik 3 notwendig.

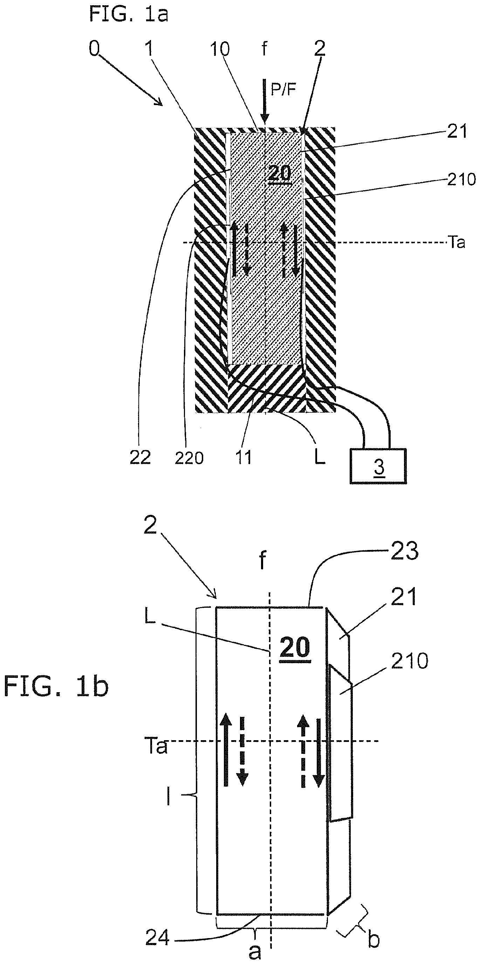

Wie in Figur 1b gezeigt, weist der Körper 20 eine Länge 1 zwischen einer ersten. Stirnfläche 23 und einer zweiten Stirnfläche 24 verlaufend, eine sich in Transversalrichtung Ta erstreckende Dicke a, sowie eine Breite b auf. Die Länge 1 ist dabei wesentlich grösser als die Breite b und die Dicke a gewählt, wodurch eine stabförmige Gestaltung des Körpers 20 erreicht ist. Aufgrund der perspektivischen Ansicht ist nur die erste Seitenfläche 21 mit erster Seitenflächenelektrode 210 dargestellt. Die zweite Seitenfläche 22 und die zweite Seitenflächenelektrode 220 sind verdeckt. Die Seitenflächenelektroden 210, 220 sind flächig auf den Seitenflächen 21, 22 angeordnet, wobei eine vollflächige Gestaltung zur Verbesserung der Messergebnisse vorteilhaft sein kann. Die Seitenflächenelektroden 210, 220 können die Seitenflächen 21, 22 auch nur teilweise bedecken und mit teilweise runder oder elliptisch geformter Grundfläche ausgeführt sein.

Der Körper 20 des Messelementes 2 ist aus einem piezoelektrischen Material gebildet, welches die Ausnutzung beider piezoelektrischen Effekte gleichzeitig erlaubt.

Die Piezoelektrizität in einem piezoelektrischen Material, hier im Körper 20 wird bekanntlich durch piezoelektrische Tensoren mit piezoelektrischen Koeffizienten beschrieben.

Ein piezoelektrischer d-Tensor dijk, ein Tensor dritter Stufe, beschreibt die erzeugte Verzerrung S des Körpers 20 als Folge eines angelegten elektrischen Feldes E oder das erzeugte elektrische Verschiebungsfeld D des Körpers 20 als Funktion des mechanischen Spannungszustands T.

Der d-Tensor dijk ist definiert durch

$$d_{ijk} = \frac{\partial D_i}{\partial T_{jk}} = \frac{\partial S_{jk}}{\partial E_i},$$

i = 1...3, j = 1...3

Wobei, D der Vektor des elektrischen Verschiebungsfeldes, T der Spannungstensor, S der Dehnungstensor und E der Vektor des elektrischen Feldes ist.

Beim ersten Messmodus wird der piezoelektrische Effekt hier in Transversalrichtung Ta ausgenutzt, wobei die Kräfte F in Richtung parallel zur Longitudinalachse L auf den Körper 20 wirken. Aufgrund der Verschiebung von Ionen im piezoelektrischen Material kommt es zu einer Polarisation, da die Ladungsschwerpunkte der negativen und positiven Ladungen in jeder Einheitszelle des piezoelektrischen Materials relativ zueinander verschoben werden. In Transversalrichtung Ta kann dann eine Spannung oder Ladung gemessen werden.

Wenn das Material des piezoelektrischen Körpers 20 so gewählt ist, dass ein Transversalkoeffizient dijj des piezoelektrischen d-Tensors dijk ungleich Null ist, dann kann der Transversaleffekt ausgenutzt werden, wobei bei Wirkung einer äusseren Kraft F in Richtung der Längsachse L eine Ladungsverschiebung in Transversalrichtung Ta, welche orthogonal zur Längsachse L verläuft, resultiert. Damit der piezoelektrische Effekt, in Form des Transversaleffektes ausnutzbar ist, wobei Kräfte F auf die Stirnflächen 23, 24 in Richtung Längsachse L wirkend zur Erzeugung elektrischer Spannungen führen, muss der Körper 20 eine Transversalempfindlichkeit, senkrecht zur Längsachse L gerichtet ungleich Null aufweisen.

Der Körper 20 bzw. das piezoelektrische Material muss darum derart gewählt sein, dass der Transversalkoeffizient dijj des piezoelektrischen d-Tensors dijk ungleich Null ist, für i = 1..3 und j = 1..3. Der Transversalkoeffizient dijj wird in Coloumb pro Newton angegeben und kann für gewählte Materialien gemessen bzw. Tabellen entnommen werden.

Wird ein Material des Körpers 20 gewählt, welches einen Transversalkoeffizienten dijj gleich Null aufweist, kann der transversale piezoelektrische Effekt nicht ausgenutzt werden.

Um den statischen Druck gleichzeitig mit demselben Messelement 2 messen zu können, wird der piezoelektrische Körper 20 zeitgleich als Dickenscherschwinger betrieben. Dabei regt die Auswerte- und Anregungselektronik 3 den piezoelektrischen Körper 20 mit einer Dickenscherschwingungsfrequenz f zu Schwingungen an.

In Figur 2 ist die Scherung im Körper 20 bei angeregter Dickenscherschwingung durch die erste und die zweite Seitenflächenelektrode 210, 220 schematisch angedeutet gezeigt. Dabei findet die Scherung des Körpers 20 praktisch nur im Bereich der Seitenflächenelektroden 210, 220 statt, wobei an den Enden keine bzw. fast keine Scherung auftritt. Bei Einwirkung einer Kraft F parallel zur Longitudinalrichtung L ändert sich die Dickenscherschwingungsfrequenz f, woraus auf die Grösse des Druckes P geschlossen werden kann. Der Körper 20 wird mit elektrischer Wechselspannung beaufschlagt und dabei mit Frequenzen im Megaherzbereich, bevorzugt zwischen 0.5 und 100 MHz zu Dickenscherschwingungen angeregt und damit als Dickenschwerschwinger eingesetzt.

Bei diesem zweiten Messmodus wird der inverse piezoelektrische Effekt ausgenutzt, was hier gleichzeitig mit der Ausnutzung des direkten piezoelektrischen Effektes passiert.

Damit der Körper 20 bzw. das piezoelektrische Material als Dickenschwerschwinger einsetzbar ist und der inverse piezoelektrische Effekt ausnutzbar ist, muss der Schubkoeffizient eiij des piezoelektrischen e-Tensors eijk ungleich Null sein, für i = 1..3 und j = 1..3.

$$e_{ijk} = \frac{\partial D_i}{\partial S_{jk}} = -\frac{\partial T_{jk}}{\partial E_i},$$

$i = 1...3, j = 1...3$

Um eine möglichst hohe Schwingungsgüte des Körpers 20 bei Verwendung als Dickenscherschwinger zu erreichen, sollte der Betrag des Schubkoeffizienten eiij des piezoelektrischen e-Tensors eijk möglichst gross sein. Wenn der Betrag des Schubkoeffizienten eiij Null ist, ist keine Dickenscherschwingung erreichbar und entsprechend der Körper 20 nicht als Dickenscherschwinger einsetzbar.

Wie in Figur 1b gezeigt, kann bei Verwendung eines geeigneten piezoelektrischen Materials ein Körper 20 mit ausschliesslich Seitenflächenelektroden 210, 220 verwendet werden, wobei der piezoelektrische Transversaleffekt und gleichzeitig durch elektrische Anregung des Körpers 20 mittels Anschluss einer Auswerte- und Anregungselektronik 3 an den Seitenflächenelektroden 210, 220 eine Dickenscherschwingung erzeugt und damit der inverse piezoelektrische Effekt ausgenutzt werden kann, um Kräfte bzw. Drücke und/oder die Temperatur zu messen bzw. zu bestimmen.

Die Bedingungen für den piezoelektrischen Körper 20 sind die Anordnung der Seitenflächenelektroden 210, 220, die Wahl eines piezoelektrischen Materials mit Schubkoeffizient eiij des piezoelektrischen e-Tensors e ungleich Null und zusätzlich ein Transversalkoeffizient dijj des piezoelektrischen d-Tensors dijk ungleich Null.

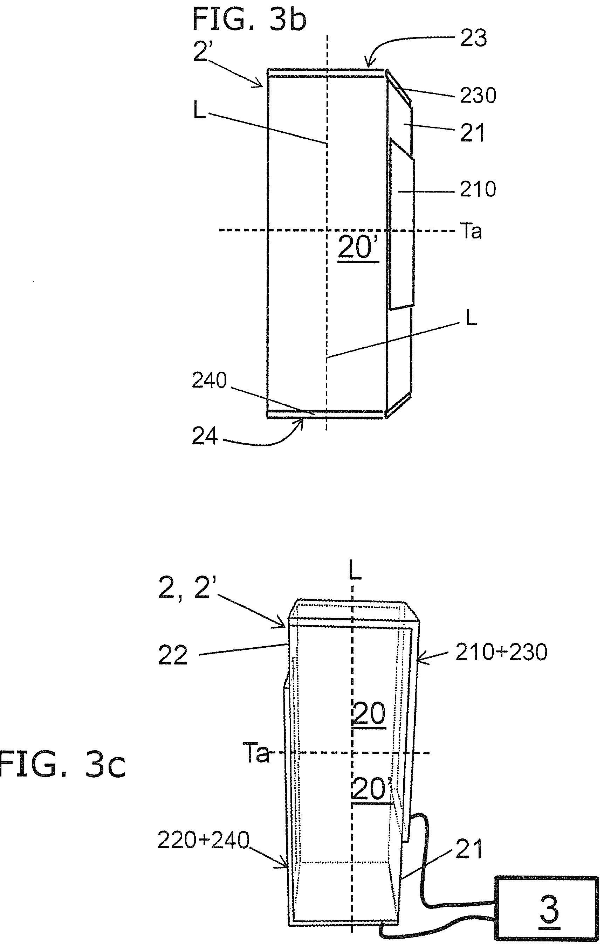

In Figur 3a ist ein Messelement 2' innerhalb einer Messelementaufnahme 1 angeordnet gezeigt, welches einen Körper 20' aufweist, welcher den direkten piezoelektrischen Effekt in Longitudinalrichtung L aufweist. Bei diesem Longitudinaleffekt sind die Richtung der Kraftwirkung und die Richtung der Ladungsverschiebung gleich. Dafür sind in diesem Fall Stirnflächenelektroden 230, 240 an in Longitudinalrichtung L beabstandeten Stirnflächen 23, 24 angeordnet. Die Stirnflächenelektroden 230, 240 überdecken hier die Stirnflächen 23, 24 vollständig.

Die Stirnflächenelektroden 230, 240 sowie die Seitenflächenelektroden 210, 220 sind auf die jeweiligen Flächen mit bekannten Verfahren aufgedampft, beispielsweise mit Physikalische Gasphasenabscheidung (PVD)- oder Chemische Gasphasenabscheidung (CVD)-Verfahren. Dabei reicht eine möglichst dünne geschlossenen Elektrodenschicht aus.

Die Auswerte- und Anregungselektronik 3 ist hier über Zuleitungen mit den Stirnflächenelektroden 230, 240 und den Seitenflächenelektroden 210, 220 verbunden. Bei Krafteinwirkung in Longitudinalrichtung L ist eine Ladung zwischen den Stirnflächenelektroden 230, 240 über Zuleitungen von der Auswerte- und Anregungselektronik 3 aufgrund des Longitudinaleffektes messbar. Bei zeitgleicher Anregung des Körpers 20' und Betrieb als Dickenscherschwinger ist ebenfalls gleichzeitig der inverse piezoelektrische Effekt in Transversalrichtung Ta wie bereits beschrieben messbar.

Die Bedingungen für den piezoelektrischen Körper 20' sind die Anordnung der Seitenflächenelektroden 210, 220 und der Stirnflächenelektroden 230, 240, sowie die Wahl eines piezoelektrischen Materials mit Schubkoeffizient eiij des piezoelektrischen e-Tensors eijk ungleich Null und zusätzlich einem Longitudinalkoeffizient diii des piezoelektrischen d-Tensors dijk ungleich Null.

Um eine möglichst hohe Schwingungsgüte des Dickenscherschwingers zu erreichen, sollte das piezoelektrische Material bzw. der Körper 20, 20' einen elektromechanischen Kopplungsfaktor kiij$^2$ jeweils grössergleich 0.001, vorzugsweise grössergleich 0.01 aufweisen. Der Kopplungsfaktor kiij$^2$ stellt in einem piezoelektrischen Material das Verhältnis von gespeicherter mechanischer Energie zur aufgenommenen elektrischen Energie dar.

Die in Messelementen eingesetzten Materialien waren bisher entweder auf den direkten oder den inversen piezoelektrischen Effekt optimiert, weshalb Messelemente mit einer Mehrzahl von Körpern verwendet werden mussten.

In Figur 3b ist ein Messelement 2' mit einem piezoelektrischen Körper 20', der einen longitudinalen piezoelektrischen Effekt zeigt, beispielhaft gezeigt, wobei in Longitudinalrichtung L voneinander beabstandet und einander gegenüberliegend eine erste Stirnfläche 23 und eine zweite Stirnfläche 24 angeordnet ist. Die erste Stirnfläche 23 ist mit einer ersten Stirnflächenelektrode 230 und die zweite Stirnfläche 24 mit einer zweiten Stirnflächenelektrode 240 versehen. Die Stirnflächenelektroden 230, 240 werden an eine hier nicht dargestellte Auswerte- und Anregungselektronik angeschlossen. Bei Kraftwirkung in Longitudinalrichtung auf den Körper 20' kann eine elektrische Spannung zwischen den Stirnflächenelektroden 230, 240 abgegriffen werden oder Ladungen gemessen werden. Da auch hier die Seitenflächenelektroden 210, 220 in Transversalrichtung Ta an gegenüberliegenden Seitenflächen 21, 22 angeordnet sind und der Körper 20' ebenfalls als Dickenscherschwinger betreibbar ist, kann hier gleichzeitig mit dem Longitudinaleffekt der inverse piezoelektrische Effekt zur Druckmessung und/oder zur Temperaturmessung ausgenutzt werden.

In einer leicht abgewandelten Form des Messelementes 2, 2', weist der Körper 20, 20' eine spezielle Gestaltung der Elektroden auf. Dabei ist die erste Seitenflächenelektrode 210 leitend mit der ersten Stirnflächenelektrode 230 verbunden, wobei eine Verbindung über die zwischen der ersten Seitenfläche 21 und der ersten Stirnfläche 23 liegende Ecke des Körpers 20, 20' erzeugt ist. Entsprechend ist die zweite Seitenflächenelektrode 220 leitend mit der zweiten Stirnflächenelektrode 240 verbunden. Diese Verbindung ist über eine Ecke des Körpers 20, 20' zwischen zweiter Seitenfläche 22 und zweiter Stirnfläche 24 erzeugt. Der Körper 20, 20' kann so gewählt sein, dass er den inversen piezoelektrischen Effekt aufweist und wahlweise den Transversaleffekt und/oder den Longitudinaleffekt.

Vor allem ist eine leitende Verbindung benachbarter Seitenflächenelektroden 210, 220 und Stirnflächenelektroden 230, 240 vorteilhaft, wenn der Körper 20, 20' den Longitudinaleffekt bzw. Transversaleffekt aufweist und als Dickenscherschwinger betrieben werden soll. In einem solchen Fall braucht die Auswerte- und Anregungselektronik 3 nur mittels zweier Zuleitungen am Körper 20, 20' angeschlossen werden.

Als piezoelektrisches Material für den Körper 20, 20' können Piezokeramiken eingesetzt werden, welche so gewählt werden, dass sie die oben aufgestellten Bedingungen je nach Verwendungszweck erfüllen. Geeignete Piezokeramiken liegen in Form eines Blei-Zirkonat-Titanats (PZT, Pb $[Zr_x Ti_{1-x}]O_3$, $0 \leq x \leq 1$), eines Wismut-Titanats oder eines Blei-Meta-Niobats, beispielsweise $PbNb_2O_6$ vor.

Es können aber auch piezoelektrische Materialien für den Körper 20, 20' in Form monokristalliner Werkstoffe eingesetzt werden, wie zum Beispiel Turmalin, Lithiumniobat (LiNbO3), Lithiumtantalat (LiTaO3), Oxyborat in Form von ReCa4O(BO3)3 mit Re als seltene Erde (Y, Gd, La) oder Kristalle, welche der kristallographischen Raumgruppe P321 angehören, wie zum Beispiel $\alpha$-Quarz ($\alpha$-SiO2) oder Galliumorthophosphat (GaPO4). Weitere Kristalle dieser Raumgruppe weisen eine Langasit (La3Ga5SiO14) - analoge Kristallstruktur auf wie zum Beispiel, Langatat (La3Ga5.5Ta0.5O14) oder Langanit (La3Ga5.5Nb0.5O14), Ca3Ga2Ge4O14, LaGa5GeO14, Ca3TaGa3SiO14, Ca3NbGa3SiO14, Sr3TaGa3SiO14 oder Sr3NbGa3SiO14.

Einkristalle können hochrein gezüchtet werden oder sind bereits kommerziell erhältlich, wobei eben auch natürlich nicht vorkommende Kristalle, wie beispielsweise Langasit, gezielt gezüchtet werden können. Damit die oben aufgestellten Bedingungen von piezoelektrischen Körpern 20, 20' aus solchen Einkristallen erfüllt werden, muss eine gezielte Präparation erfolgen.

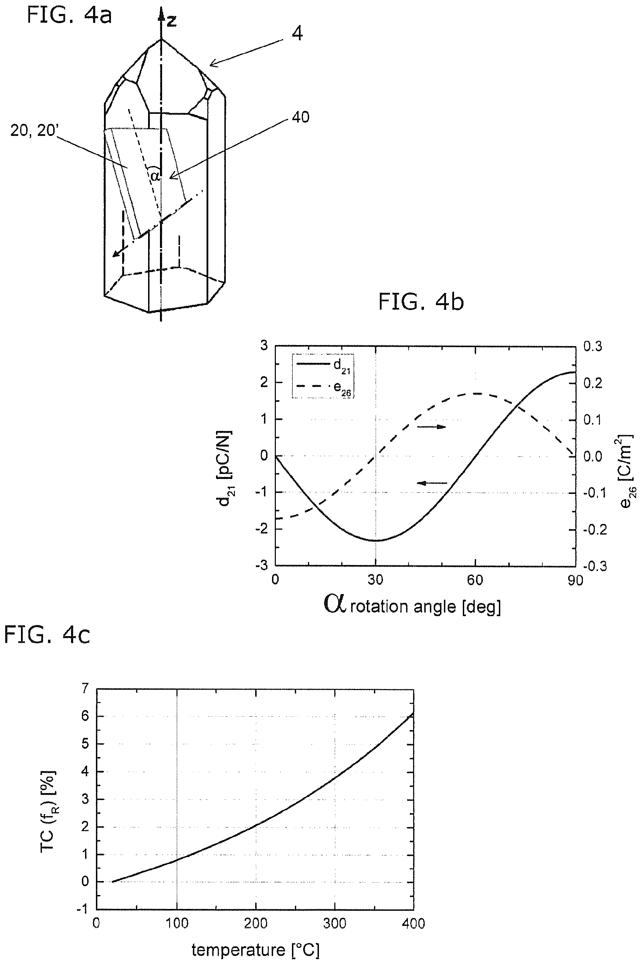

Wie in Figur 4a schematisch an einem Quarzkristall 4 mit einer Hauptachse z gezeigt, erfolgt ein Schnitt des Quarzkristalls 4 in einer Schnittebene 40 in einem Schnittwinkel $\alpha$ relativ zur Hauptachse z des Quarzkristalls 4. Je nach Wahl des Winkels $\alpha$ weist der herausgeschnittene piezoelektrische Körper 20, 20' unterschiedliche Transversalkoeffizienten dijj, Longitudinalkoeffizienten diii und Schubkoeffizienten eiij auf.

Beispielhaft ist in Figur 4b ein Diagramm für einen Quarzkristall gezeigt, wobei unterschiedlichen Schnittwinkeln $\alpha$ relativ zur Hauptachse z der jeweils entsprechende winkelabhängige Transversalkoeffizient dijj und Schubkoeffizient eiij zugeordnet ist.

Bei 0° (oder auch 60°) ist der Koeffizient e221 maximal, was für die Erzeugung der Dickenscherschwingung ideal ist, da die höchste Schwingungsgüte erreicht ist. Leider ist der Koeffizient d211 null, somit ist kein Transversaleffekt vorhanden. Bei einer Rotation von 30° (oder auch 90°) ist die Transversalempfindlichkeit am höchsten, da d211 maximal ist, aber der Koeffizient e221 ist null und es wird keine Dickenscherschwingung erzeugt.

Die Bedingung, dass beide Koeffizienten dijj, eiij ungleich Null sind, ist bei Schnittwinkeln $\alpha$ von zwischen 5° und 25°, 35° und 55°, sowie zwischen 65° und 85° erreicht. Für Einkristalle kann entsprechend der piezoelektrische Körper 20, 20' so erzeugt werden, dass die Bedingungen erfüllt sind und eine Dickenscherschwingung mit ausreichender Schwingungsgüte erzeugt werden kann und gleichzeitig der piezoelektrische Effekt ausnutzbar ist.

Für Einkristalle können Winkel $\alpha$ gefunden werden, sodass der herausgeschnittene piezoelektrische Körper 20, 20' von Null verschiedene Longitudinalkoeffizienten diii und gleichzeitig von Null verschiedene Schubkoeffizienten eiij aufweisen. Damit können piezoelektrische Körper 20, 20' aus Einkristallen derart herausgeschnitten werden, dass die gewünschten piezoelektrischen Eigenschaften erreicht werden.

Die Resonanzfrequenz $f_R$ eines Dickenscherschwingers hängt hauptsächlich von dem Elastizitätsmodul $c_{66}$, von der Kristalldichte p und von der Dicke d des Schwingers, gemäss folgender Formel ab:

$$f_R(T) = \frac{1}{2d(T)} \sqrt{\frac{c_{66}(T)}{\rho(T)}}$$

Elastizitätsmodul, Kristalldichte und Dicke sind abhängig von der Temperatur T, somit verschiebt sich die Resonanzfrequenz wenn sich die Temperatur des Schwingers ändert. Die Temperatur kann somit anhand der Bestimmung der Resonanzfrequenz des Dickenscherschwingers ermittelt werden. Die relative Abweichung der Resonanzfrequenz TC($f_R$) in Abhängigkeit der Temperatur ist als Beispiel für Quarz in Figur 4c dargestellt.

Falls der Elastizitätsmodul $c_{66}$ auch noch von den mechanischen Spannungen abhängt, so kann die Formel für die Resonanzfrequenz $f_R$ ausgeweitet werden:

$$f_R(T,F) = \frac{1}{2d(T)} \sqrt{\frac{c_{66}(T,F)}{\rho(T)}} \; ,$$

wo F die auf dem Dickenscherschwinger wirkende Kraft ist. Anhand der Bestimmung der Resonanzfrequenz kann somit auch eine Kraft gemessen werden. Dieses Prinzip wird zum Beispiel mit dem AT-Schnitt des Quarzschwingers verwendet, um Kraftsensoren herzustellen.

Selbstverständlich können für die Bestimmung von Kraft oder Druck oder Temperatur auch Oberschwingungen der Dickenschwerschwingungen ausgewertet werden.

Bezugszeichenliste

0   Sensorstruktur
1   Messelementaufnahme
    10 Membran
    11 Widerlager
2   Messelement
    20 Körper (Piezokristall oder Piezokeramik)
    21 erste Seitenfläche
    210 erste Seitenflächenelektrode
    22 zweite Seitenfläche
    220 zweite Seitenflächenelektrode
    23 erste Stirnfläche
    230 erste Stirnflächenelektrode
    24 zweite Stirnfläche
    240 zweite Stirnflächenelektrode
    Ta Transversalrichtung
    L Longitudinalrichtung
    d piezoelektrischer d-Tensor (Tensor dritter Stufe)
    $d_{ijj}$ Transversalkoeffizient
    $d_{iii}$ Longitudinalkoeffizient
    e piezoelektrischer e-Tensor
    $e_{iij}$ Schubkoeffizient
    $k_{iij}$ elektromechanischer Kopplungsfaktor
    D Vektor des elektrischen Verschiebungsfeldes
    T Spannungstensor
    S Dehnungstensor
    E Vektor des elektrischen Feldes
    1 Länge
    a Dicke
    b Breite
    F Kraft
    P Druck
    f Dickenscherschwingungsfrequenz
3   Auswerte- und Anregungselektronik
4   Quarzkristall
    40 Schnittebene
    z Hauptachse
    $\alpha$ Schnittwinkel relativ zur Hauptachse

**Patentansprüche**

1.  Sensorstruktur (0) mit einer Messelementhalterung (1) und mit einem Messelement (2) zur Messung des dynamischen Druckes und zusätzlich zur Messung der Temperatur und/oder des statischen Druckes, welches Messelement (2) einen Körper (20, 20') aus einem piezoelektrischen Material umfasst, wobei der Körper (20, 20') einander in einer Transversalrichtung (Ta) gegenüberliegend angeordnete Seitenflächen (21, 22) aufweist, an welchen jeweils Seitenflächenelektroden (210, 220) angeordnet sind, wobei das Messelement (2) in Longitudinalrichtung (L) in der Messelementhalterung (1) zur Ausnutzung des piezoelektrischen Effektes vorgespannt angeordnet ist und einer Kraft (F) aussetzbar ist, **dadurch gekennzeichnet, dass** das piezoelektrische Material des Körpers (20, 20') derart gewählt ist, dass ein Schubkoeffizient ($e_{iij}$) des piezoelektrischen e-Tensors ($e_{ijk}$) ungleich Null ist (mit i (i = 1..3) und j (j = 1..3)), womit der inverse piezoelektrische Effekt bei Betrieb als Dickenscherschwinger zur Messung der Temperatur und/oder des statischen Druckes ausnutzbar ist, indem die Seitenelektroden (210, 220) über Zuleitungen mit einer Auswerte- und Anregungselektronik (3) verbindbar sind und der piezoelektrische Körper (20, 20') mit einer Dickenschwingungsfrequenz (f) zu Schwingungen anregbar ist, sowie dass zusätzlich ein Transversalkoeffizient ($d_{ijj}$) des piezoelektrischen d-Tensors ($d_{ijk}$) ungleich Null ist (mit i (i = 1..3) und j (j = 1..3)), womit der transversale piezoelektrische Effekt in Transversalrichtung (Ta) gleichzeitig mit dem inversen piezoelektrischen Effekt durch den selben Körper (20, 20') ausgenutzt wird.

2.  Sensorstruktur (0) mit einer Messelementhalterung (1) und mit einem Messelement (2) zur Messung des dynamischen Druckes und zusätzlich zur Messung der Temperatur und/oder des statischen Druckes, welches Messelement (2) einen Körper (20, 20') aus einem piezoelektrischen Material umfasst, wobei der Körper (20, 20') einander in einer Transversalrichtung (Ta) gegenüberliegend angeordnete Seitenflächen (21, 22) aufweist, an welchen jeweils Seitenflächenelektroden (210, 220) angeordnet sind, wobei das Messelement (2) in Longitudinalrichtung (L) in der Messelementhalterung (1) zur Ausnutzung des piezoelektrischen Effektes vorgespannt angeordnet ist und einer Kraft (F) aussetzbar ist, **dadurch gekennzeichnet, dass** das piezoelektrische Material des Körpers (20, 20') derart gewählt ist, dass ein Schubkoeffizient ($e_{iij}$) des piezoelektrischen e-Tensors ($e_{ijk}$) ungleich Null ist (mit i (i = 1..3) und j (j = 1..3)), womit der inverse piezoelektrische Effekt bei Betrieb als Dickenscherschwinger zur Messung der Temperatur und/oder des statischen Druckes ausnutzbar ist, indem die Seitenelektroden (210, 220) über Zuleitungen mit einer Auswerte- und Anregungselektronik (3) verbindbar sind und der piezoelektrische Körper (20, 20') mit einer Dickenschwingungsfrequenz (f) zu Schwingungen anregbar ist, sowie dass zusätzlich ein Longitudinalkoeffizient ($d_{iii}$) des piezoelektrischen d-Tensors ($d_{ijk}$) ungleich Null ist (mit i (i = 1..3) und j (j = 1..3)), womit der longitudinale piezoelektrische Effekt in Longitudinalrichtung (L) gleichzeitig mit dem inversen piezoelektrischen Effekt durch den selben Körper (20, 20') ausgenutzt wird, und dass der Körper (20, 20') an einander in Longitudinalrichtung (L) gegenüberliegend angeordneten Stirnflächen (23, 24) Stirnflächenelektroden (230, 240) aufweist, welche über Zuleitungen mit der Auswerte- und Anregungselektronik (3) verbindbar sind, sodass der Longitudinaleffekt an den Stirnflächenelektroden (230, 240) messbar ist und gleichzeitig der inverse piezoelektrische Effekt an den Seitenflächenelektroden (210, 220) anregbar und messbar ist.

3. Sensorstruktur (0) nach Anspruch 1 oder 2, **wobei** das piezoelektrische Material des Körpers (20, 20') zur Erreichung einer möglichst hohen Schwingungsgüte einen elektromechanischen Kopplungsfaktor (kiij$^2$) grössergleich 0.001, vorzugsweise grössergleich 0.01 aufweist.

4. Sensorstruktur (0) nach einem der vorhergehenden Ansprüche, **wobei** der piezoelektrische Körper (20, 20') aus einem piezoelektrischen Einkristall herausgeschnitten ist, wobei die Schnittebene (40) entlang eines Schnittwinkels ($\alpha$) zur Hauptachse (z) des piezoelektrischen Einkristalls derart orientiert gewählt ist, dass der Schubkoeffizient (eiij), der Transversalkoeffizient (dijj) und/oder der Longitudinalkoeffizient (diii) des resultierenden Körpers (20, 20') ungleich Null ist.

5. Sensorstruktur (0) nach einem der vorhergehenden Ansprüche, **wobei** das piezoelektrische Material ein piezoelektrischer monokristalliner Werkstoff, vorzugsweise Turmalin, LiNbO3, LiTaO3 oder ein Oxyborat in Form von Re-Ca4O(BO3)3 mit Re als seltene Erde (Y, Gd, La) ist.

6. Sensorstruktur (0) nach einem der Ansprüche 1 bis 4, **wobei** das piezoelektrische Material ein piezoelektrischer monokristalliner Werkstoff ist, welcher aus dem kristallographischen Raumgruppe P321 besteht, vorzugsweise aus Quarz oder aus GaPO4.

7. Sensorstruktur (0) nach einem der Ansprüche 1 bis 4, **wobei** das piezoelektrische Material ein Kristall mit einer Langasit (La3Ga5SiO14) - analogen Kristallstruktur, vorzugsweise La3Ga5.5Ta0.5O14, La3Ga5.5Nb0.5O14, Ca3Ga2Ge4O14, La3Ga5Ge0.5O14, Ca3TaGa3SiO14, Ca3NbGa3SiO14, Sr3TaGa3SiO14, Sr3NbGa3SiO14, Ca3Ga2Ge4O14 oder Sr3Ga2Ge4O14 ist.

8. Sensorstruktur (0) gemäss einem der Ansprüche 1 bis 3, **wobei** das piezoelektrische Material des Körpers (20, 20') eine Piezokeramik in Form eines Blei-Zirkonat-Titanats (PZT, Pb[Zr$_x$Ti$_{1-x}$]O$_3$, $0 \leq x \leq 1$), eines Wismut-Titanats oder eines Blei-Meta-Niobats, vorzugsweise PbNb$_2$O$_6$ ist.

9. Sensorstruktur (0) nach einem der vorhergehenden Ansprüche, **wobei** der Körper (20, 20') an einander in Longitudinalrichtung (L) gegenüberliegend angeordneten Stirnflächen (23, 24) Stirnflächenelektroden (230, 240) aufweist, **wobei** die erste Seitenflächenelektrode (210) mit einer ersten Stirnflächenelektrode (230), sowie die zweite Seitenflächenelektrode (220) mit einer zweiten Stirnflächenelektrode (240) elektrische leitend verbunden sind, wodurch das Messelement nur mittels zweier Zuleitungen mit einer Anregungselektronik (3) verbunden zu werden braucht, um das Messelement zu betreiben.

10. Sensorstruktur (0) umfassend eine Messelementaufnahme (1) in welcher ein Messelement (2, 2') nach einem der vorhergehenden Ansprüche wirkverbunden eingespannt gehalten ist, **wobei** das Messelement (2, 2') mit einer Auswerte- und Anregungselektronik (3) verbunden ist und neben dem piezoelektrischen Effekt gleichzeitig der inverse piezoelektrische Effekt ausgenutzt wird.

11. Sensorstruktur (0) nach Anspruch 10, **wobei** die Anregungselektronik (3) mittels zweier Zuleitungen zum einen an einer ersten Seitenflächenelektrode (210), welche elektrisch leitend mit einer ersten Stirnflächenelektrode (230) verbunden ist und zum zweiten an einer zweiten Seitenflächenelektrode (220), welche elektrisch leitend mit einer zweiten Stirnflächenelektrode (240) verbunden ist, mit dem Messelement (2, 2') verbunden ist.

12. Verfahren zur Messung des dynamischen Druckes und zusätzlich zur Messung des statischen Drucks und/oder der Temperatur mit einem Messelement, umfassend einen piezoelektrischen Körper (20), welcher in Longitudinalrichtung (L) in eine Messelementaufnahme (1) eingespannt gelagert ist, wobei der piezoelektrische Körper (20) Seitenflächen (21, 22) in einer Transversalrichtung (Ta) voneinander beabstandet mit darauf angeordneten Seitenflächenelektroden (210, 220) aufweist, **gekennzeichnet dadurch, dass** das Messelement ein Messelement (2,2') gemäss einem der Ansprüche 1 bis 8 ist, das Messelement (2, 2') über Zuleitungen an einer Auswerte- und Anregungselektronik (3) wirkverbunden angeschlossen ist, wobei das Messelement (2, 2') als Dickenscherschwinger unter elektronischer Schwingungsanregung mit einer Dickenscherschwingungsfrequenz (f) mittels der Auswerte- und Anregungselektronik (3) betrieben wird und Frequenzabweichungen aufgrund äusserer Kräfte (F) und/oder der Temperatur zur Ermittlung des statischen Druckes und/oder der Temperatur genutzt werden und das Messelement (2, 2') zeitgleich eine Messung des direkten piezoelektrischen Effektes in Transversalrichtung (Ta) und/oder eine Messung des direkten piezoelektrischen Effektes in Longitudinalrichtung (L) bei Anordnung von Stirnflächenelektroden (230, 240) auf voneinander in Longitudinalrichtung (L) beabstandeten Stirnflächen (23, 24) mittels der Auswerte- und Anregungselektronik (3) zur Bestimmung des dynamischen Druckes erlaubt.

## Claims

1. A sensor structure (0) comprising a measuring element holder (1) and a measuring element (2) for measuring the dynamic pressure and additionally for measuring the temperature and/or the static pressure, said measuring element (2) comprising a body (20, 20') made of a piezoelectric material, wherein the body (20, 20') comprises lateral surfaces (21, 22) arranged opposite of one another in a transversal direction (Ta) at each of which are arranged lateral surface electrodes (210, 220), wherein the measuring element (2) is mounted in the longitudinal direction (L) in the measuring element holder (1) in a prestressed manner for utilizing the piezoelectric effect and can be exposed to a force (F), **characterized in that** the piezoelectric material of the body (20, 20') is chosen to have a shear coefficient (eiij) of the piezoelectric e-tensor (eijk) that is not equal to zero (with i (i = 1..3) and j (j = 1..3)) so that the inverse piezoelectric effect can be utilized during operation as a thickness shear oscillator for measuring the temperature and/or the static pressure, by enabling the lateral electrodes (210, 220) to be connected to evaluation and excitation electronics (3) by means of supply lines and the piezoelectric body (20, 20') to be excited with a thickness oscillation frequency (f) to perform oscillations, and **in that** additionally a transverse coefficient (dijj) of the piezoelectric d-tensor (dijk) is not equal to zero (with i (i = 1..3) and j (j = 1..3)) so that the transverse piezoelectric effect in the transversal direction (Ta) is utilized simultaneously with the inverse piezoelectric effect by the same body (20, 20').

2. A sensor structure (0) comprising a measuring element holder (1) and a measuring element (2) for measuring the dynamic pressure and additionally for measuring the temperature and/or the static pressure, said measuring element (2) comprising a body (20, 20') made of a piezoelectric material, wherein the body (20, 20') comprises lateral surfaces (21, 22) arranged opposite of one another in a transversal direction (Ta) at each of which are arranged lateral surface electrodes (210, 220), wherein the measuring element (2) is mounted in the longitudinal direction (L) in the measuring element holder (1) in a prestressed manner for utilizing the piezoelectric effect and can be exposed to a force (F), **characterized in that** the piezoelectric material of the body (20, 20') is chosen to have a shear coefficient (eiij) of the piezoelectric e-tensor (eijk) that is not equal to zero (with i (i = 1..3) and j (j = 1..3)) so that the inverse piezoelectric effect can be utilized during operation as a thickness shear oscillator for measuring the temperature and/or the static pressure, by enabling the lateral electrodes (210, 220) to be connected to evaluation and excitation electronics (3) by means of supply lines and the piezoelectric body (20, 20') to be excited with a thickness oscillation frequency (f) to perform oscillations, and **in that** additionally a longitudinal coefficient (diii) of the piezoelectric d-tensor (dijk) is not equal to zero (with i (i = 1..3) and j (j = 1..3)) so that the longitudinal piezoelectric effect in the longitudinal direction (L) is utilized simultaneously with the inverse piezoelectric effect by the same body (20, 20'), and **in that** the body (20, 20') comprises end face electrodes (230, 240) arranged at end faces (23, 24) that lie opposite of one another in the longitudinal direction (L), which end face electrodes (230, 240) can be connected to evaluation and excitation electronics (3) by means of supply lines, so that the longitudinal effect can be measured at the end face electrodes (230, 240) and simultaneously the inverse piezoelectric effect can be excited and measured at the lateral surface electrodes (210, 220).

3. The sensor structure (0) according to claim 1 or 2, **wherein** the piezoelectric material of the body (20, 20') has an electromechanical coupling factor (kiij$^2$) of greater than or equal to 0.001, preferably greater than or equal to 0.01, in order to achieve an as high oscillation quality as possible.

4. The sensor structure (0) according to any of the preceding claims, **wherein** the piezoelectric body (20, 20') is cut from a piezoelectric single crystal, wherein the cutting plane (40) is chosen to be oriented along a cutting angle (a) relative to the main axis (z) of the piezoelectric single crystal so that the shear coefficient (eiij), transverse coefficient (dijj) and/or longitudinal coefficient (diii) of the resulting body (20, 20') is different from zero.

5. The sensor structure (0) according to any of the preceding claims, **wherein** the piezoelectric material is a piezoelectric single-crystalline material, preferably tourmaline, LiNbO3, LiTaO3 or an oxyborate in the form of ReCa4O(BO3)3 with Re being a rare earth (Y, Gd, La).

6. The sensor structure (0) according to any of the claims 1 to 4, **wherein** the piezoelectric material is a piezoelectric single-crystalline material consisting of the crystallographic space group P321, preferably of quartz or GaPO4.

7. The sensor structure (0) according to any of the claims 1 to 4, **wherein** the piezoelectric material is a crystal having a crystalline structure analogous to langasite (La3Ga5SiO14), preferably La3Ga5.5Ta0.5O14, La3Ga5.5Nb0.5O14, Ca3Ga2Ge4O14, La3Ga5Ge0.5O14, Ca3TaGa3SiO14, Ca3NbGa3SiO14, Sr3TaGa3SiO14, Sr3NbGa3SiO14, Ca3Ga2Ge4O14 or Sr3Ga2Ge4O14.

8. The sensor structure (0) according to any of the claims 1 to 3, **wherein** the piezoelectric material of the body (20, 20') is a piezoceramic in the form of a lead-zirconate-titanate (PZT, $Pb[Zr_xTi_{1-x}]O_3$, $0 \leq x \leq 1$), a bismuth-titanate or a lead-meta-niobate, preferably $PbNb_2O_6$.

9. The sensor structure (0) according to any of the preceding claims, **wherein** the body (20, 20') comprises end face electrodes (230, 240) arranged at end faces (23, 24) that lie opposite of one another in the longitudinal direction (L), **wherein** the first lateral surface electrode (210) is conductively connected to a first end face electrode (230), and the second lateral surface electrode (220) is conductively connected to a second end face electrode (240) so that for operating the measuring element it is only necessary to connect the measuring element to excitation electronics (3) by means of two supply lines.

10. The sensor structure (0) comprising a measuring element holding fixture (1) in which a measuring element (2, 2') according to any of the preceding claims is operatively held in a fixed manner **wherein** the measuring element (2, 2') is connected to evaluation and excitation electronics (3) and in addition to the piezoelectric effect the inverse piezoelectric effect is simultaneously utilized.

11. The sensor structure (0) according to claim 10, **wherein** the excitation electronic (3) is connected to the measuring element (2, 2') by means of two supply lines, on the one hand at a first lateral surface electrode (210) that is conductively connected to a first end face electrode (230) and on the other hand at a second lateral surface electrode (220) that is conductively connected to a second end face electrode (240).

12. A method for measuring the dynamic pressure and additionally for measuring the static pressure and/or the temperature by means of a measuring element comprising a piezoelectric body (20) supported in a fixed manner in the longitudinal direction (L) in a measuring element holder (1) wherein said piezoelectric body (20) comprises lateral surfaces (21, 22) spaced apart from one another in a transversal direction (Ta) and comprising lateral surface electrodes (210, 220) arranged thereon, **characterized in that** the measuring element is a measuring element (2, 2') according to any of the claims 1 to 8, the measuring element (2, 2') is operatively connected to evaluation and excitation electronics (3) via supply lines, wherein the measuring element (2, 2') is operated as a thickness shear oscillator by electronic oscillation excitation with a thickness shear oscillation frequency (f) by means of the evaluation and excitation electronics (3), and frequency deviations due to external forces (F) and/or the temperature are utilized to determine the static pressure and/or the temperature, and the measuring element (2, 2') enables the simultaneous measurement of the direct piezoelectric effect in the transversal direction (Ta) and/or the measurement of the direct piezoelectric effect in the longitudinal direction (L) due to end face electrodes (230, 240) arranged on end faces (23, 24) that are spaced apart from one another in the longitudinal direction (L) by means of the evaluation and excitation electronics (3) for determining the dynamic pressure.

## Revendications

1. Structure de capteur (0) comprenant un support d'élément de mesure (1) et un élément de mesure (2) pour mesurer la pression dynamique et en outre pour mesurer la température et/ou la pression statique, ledit élément de mesure (2) comprenant un corps (20, 20') en matériau piézoélectrique, dans lequel le corps (20, 20') comprend des surfaces latérales (21, 22) disposées en face l'une de l'autre dans une direction transversale (Ta) au niveau de chacune desquelles sont disposées des électrodes de surface latérale (210, 220), dans laquelle l'élément de mesure (2) est monté dans la direction longitudinale (L) dans le support d'élément de mesure (1) d'une manière précontrainte pour utiliser l'effet piézoélectrique et peut être exposé à une force (F), **caractérisée en ce que** le matériau piézoélectrique du corps (20, 20') est choisi pour avoir un coefficient de cisaillement (eiij) du e-tenseur piézoélectrique (eijk) qui est non nulle (avec i (i = 1..3 ) et j (j = 1..3)) de sorte que l'effet piézoélectrique inverse puisse être utilisé pendant le fonctionnement en tant qu'oscillateur vibrant en cisaillement d'épaisseur pour mesurer la température et/ou la pression statique, en permettant la connexion des électrodes latérales (210, 220) à l'électronique d'évaluation et d'excitation (3) au moyen de lignes d'alimentation et du corps piézoélectrique (20, 20') d'être excité en oscillation avec une fréquence d'oscillation en épaisseur (f), et **en ce qu'**en outre un coefficient transversal (dijj) du d-tenseur piézoélectrique (dijk) est non nulle (avec i (i = 1..3) et j (j = 1..3)) de sorte que l'effet piézoélectrique transversal dans la direction transversale (Ta) soit utilisé simultanément avec l'effet piézoélectrique inverse par le même corps (20, 20').

2. Structure de capteur (0) comprenant un support d'élément de mesure (1) et un élément de mesure (2) pour mesurer la pression dynamique et en outre pour mesurer la température et/ou la pression statique, ledit élément de mesure (2) comprenant un corps (20, 20') en matériau piézoélectrique, dans lequel le corps (20, 20') comprend des surfaces latérales (21, 22) disposées en face l'une de l'autre dans une direction transversale (Ta) au niveau de chacune desquelles sont disposées des électrodes de surface latérale (210, 220), dans laquelle l'élément de mesure (2) est monté dans la direction longitudinale (L) dans le support d'élément de mesure (1) d'une manière précontrainte pour utiliser l'effet piézoélectrique et peut être exposé à une force (F), **caractérisé en ce que** le matériau piézoélectrique du corps (20, 20') est choisi pour avoir un coefficient de cisaillement (eiij) du e-tenseur piézoélectrique (eijk) qui est non nulle (avec i (i = 1..3) et j (j = 1..3)) de sorte que l'effet piézoélectrique inverse puisse être utilisé pendant le fonctionnement en tant qu'oscillateur vibrant en cisaillement d'épaisseur pour mesurer la température et/ou la pression statique, en permettant la connexion des électrodes latérales (210, 220) à l'électronique d'évaluation et d'excitation (3) au moyen de lignes d'alimentation et du corps piézoélectrique (20, 20') d'être excité en oscillation avec une fréquence d'oscillation en épaisseur (f), et **en ce qu'**en outre un coefficient longitudinal (diii) du d-tenseur piézoélectrique (dijk) est non nulle (avec i (i = 1..3) et j (j = 1..3)) de sorte que l'effet piézoélectrique longitudinal dans la direction longitudinale (L) soit utilisé simultanément avec l'effet piézoélectrique inverse par le même corps (20, 20'), et **en ce que** le corps (20, 20') comprend des électrodes de face d'extrémité (230, 240) disposées sur des faces d'extrémité (23, 24) et agencées en face l'une de l'autre dans la direction longitudinale (L), lesquelles électrodes de face d'extrémité (230, 240) peuvent être connectées à l'électronique d'évaluation et d'excitation (3) au moyen de lignes d'alimentation, de sorte que l'effet longitudinal peut être mesuré au niveau des électrodes de face d'extrémité (230, 240) et simultanément l'effet piézoélectrique inverse peut être excité et mesuré au niveau des électrodes de surface latérale (210, 220).

3. Structure de capteur (0) selon la revendication 1 ou 2, **dans laquelle** le matériau piézoélectrique du corps (20, 20') a un facteur de couplage électromécanique (kiij2) supérieur ou égal à 0,001, de préférence supérieur ou égal à 0,01, afin d'obtenir une qualité d'oscillation aussi élevée que possible.

4. Structure de capteur (0) selon l'une quelconque des revendications précédentes, **dans laquelle** le corps piézoélectrique (20, 20') est découpé dans un monocristal piézoélectrique, dans laquelle le plan de coupe (40) est choisi pour être orienté selon un angle de coupe ($\alpha$) par rapport à l'axe principal (z) du monocristal piézoélectrique de sorte que le coefficient de cisaillement (eiij), le coefficient transversal (dijj) et/ou le coefficient longitudinal (diii) du corps (20, 20') résultant soient non nulle.

5. Structure de capteur (0) selon l'une quelconque des revendications précédentes, **dans laquelle** le matériau piézoélectrique est un matériau monocristallin piézoélectrique, de préférence la tourmaline, LiNbO3, LiTaO3 ou un oxyborate sous forme de ReCa4O(BO3)3 avec Re étant une terre rare (Y, Gd, La).

6. Structure de capteur (0) selon l'une quelconque des revendications 1 à 4, **dans laquelle** le matériau piézoélectrique est un matériau monocristallin piézoélectrique constitué du groupe d'espace cristallographique P321, de préférence du quartz ou du GaPO4.

7. Structure de capteur (0) selon l'une quelconque des revendications 1 à 4, **dans laquelle** le matériau piézoélectrique est un cristal ayant une structure cristalline analogue à la langasite (La3Ga5SiO14), de préférence La3Ga5.5Ta0.5O14, La3Ga5.5Nb0.5O14, Ca3Ga2Ge4O14., La3Ga5Ge0.5O14, Ca3TaGa3SiO14, Ca3NbGa3SiO14, Sr3TaGa3SiO14, Sr3NbGa3SiO14, Ca3Ga2Ge4O14 ou Sr3Ga2Ge4O14.

8. Structure de capteur (0) selon l'une quelconque des revendications 1 à 3, **dans laquelle** le matériau piézoélectrique du corps (20, 20') est une piézocéramique sous la forme d'un titanate-zirconate de plomb (PZT, $Pb[Zr_xTi_{1-x}]O_3$, $0 \leq x \leq 1$), d'un titanate de bismuth ou d'un méta-niobate de plomb, de préférence $PbNb_2O_6$.

9. Structure de capteur (0) selon l'une quelconque des revendications précédentes, **dans laquelle** le corps (20, 20') comprend des électrodes de face d'extrémité (230, 240) agencées au niveau des faces d'extrémité (23, 24) disposées en face l'une de l'autre en la direction longitudinale (L), **dans laquelle** la première électrode de surface latérale (210) est connectée de manière conductrice à une première électrode de face d'extrémité (230), et la seconde électrode de surface latérale (220) est connectée de manière conductrice à une seconde électrode de face d'extrémité (240) de sorte que pour faire fonctionner l'élément de mesure, il est seulement nécessaire de connecter l'élément de mesure à l'électronique d'excitation (3) au moyen de deux lignes d'alimentation.

**10.** Structure de capteur (0) comprenant un dispositif de support d'élément de mesure (1) dans lequel un élément de mesure (2, 2') selon l'une quelconque des revendications précédentes est supporté fonctionnellement d'une manière fixe, **dans laquelle** l'élément de mesure (2, 2') est connecté à l'électronique d'évaluation et d'excitation (3) et dans laquelle, outre l'effet piézoélectrique, l'effet piézoélectrique inverse est simultanément utilisé.

**11.** Structure de capteur (0) selon la revendication 10, **dans laquelle** l'électronique d'excitation (3) est reliée à l'élément de mesure (2, 2') au moyen de deux lignes d'alimentation, d'une part au niveau d'une première électrode de surface latérale (210) qui est connectée de manière conductrice à une première électrode de face d'extrémité (230) et d'autre part au niveau d'une seconde électrode de surface latérale (220) qui est connectée de manière conductrice à une seconde électrode de face d'extrémité (240).

**12.** Procédé pour mesurer la pression dynamique et en outre pour mesurer la pression statique et/ou la température au moyen d'un élément de mesure comprenant un corps piézoélectrique (20) supporté de manière fixe dans la direction longitudinale (L) dans un support d'élément de mesure (1), dans lequel ledit corps piézoélectrique (20) comprend des surfaces latérales (21, 22) espacées les unes des autres dans une direction transversale (Ta) et comprenant des électrodes de surface latérale (210, 220) disposées au niveau de celles-ci, **caractérisé en ce que** l'élément de mesure est un élément de mesure (2, 2') selon l'une quelconque des revendications 1 à 8, l'élément de mesure (2, 2') est connecté fonctionnellement à l'électronique d'évaluation et d'excitation (3) via des lignes d'alimentation, dans lequel l'élément de mesure (2, 2') fonctionne comme un oscillateur vibrant en cisaillement d'épaisseur par excitation électronique d'oscillation avec une fréquence d'oscillation en cisaillement d'épaisseur (f) au moyen de l'électronique d'évaluation et d'excitation (3), et des écarts de fréquence dus à des forces externes (F) et/ou la température sont utilisés pour déterminer la pression statique et/ou la température, et l'élément de mesure (2, 2') permet la mesure simultanée de l'effet piézoélectrique direct dans la direction transversal (Ta) et/ou la mesure de l'effet piézoélectrique direct dans la direction longitudinale (L) grâce à l'agacement des électrodes de face d'extrémité (230, 240) sur des faces d'extrémité (23, 24) espacées l'une de l'autre dans la direction longitudinale (L) au moyen de l'électronique d'évaluation et d'excitation (3) pour déterminer la pression dynamique.

FIG. 1a

FIG. 1b

EP 3 120 123 B1

FIG. 2

FIG. 3a

14

FIG. 3b

2'

L

23

230

21

210

Ta

20'

L

240

24

FIG. 3c

2, 2'

L

22

210+230

20

Ta

20'

220+240

21

3

FIG. 4a

FIG. 4b

FIG. 4c

**IN DER BESCHREIBUNG AUFGEFÜHRTE DOKUMENTE**

**In der Beschreibung aufgeführte Patentdokumente**

- WO 2012164016 A
- EP 0065511 A